# EUROPEAN PATENT APPLICATION

(11) **EP 3 244 262 A1**
(43) Date of publication of application: **15.11.2017**
(21) Application number: 16735039.6
(22) Date of filing: 05.01.2016
(51) Int. Cl.: G03F 7/004

(54) **RADIATION-SENSITIVE COMPOSITION AND PATTERN FORMING METHOD**

(30) Priority: 08.01.2015 JP 2015002705; 15.01.2015 JP 2015006270
(71) Applicant: JSR Corporation, Minato-ku Tokyo 105-8640 (JP)
(72) Inventor: SHIRATANI Motohiro, Tokyo 105-8640 (JP); NARUOKA Takehiko, Tokyo 105-8640 (JP); NAKAGAWA Hisashi, Tokyo 105-8640 (JP)
(74) Representative: TBK
(86) International application number: PCT/JP2016/050164
(87) International publication number: WO 2016/111300

(57) **Abstract**

The present invention is directed to a radiation-sensitive resin composition containing: an organic acid; particles comprising a metal oxide as a principal component; and an acid generating agent that is capable of generating an acid upon irradiation with a radioactive ray, wherein the acid generating agent satisfies at least one of the following conditions (i) and (ii): (i) a pKa that is a logarithmic value of a reciprocal of an acid dissociation constant Ka of the acid generated from the acid generating agent is less than a pKa of the organic acid, and a van der Waals volume of the acid is no less than 2.1 x 10⁻²⁸ m³; and (ii) the acid generating agent has a plurality of groups that are capable of generating an acid, and a pKa that is a logarithmic value of a reciprocal of an acid dissociation constant Ka of the acid is smaller than the pKa of the organic acid.

## Description

### [TECHNICAL FIELD]

The present invention relates to a radiation-sensitive composition and a pattern-forming method.

### [BACKGROUND ART]

In radiation-sensitive compositions for use in microfabrication by lithography, an acid is generated at light-exposed regions by irradiation with an electromagnetic wave, e.g., a far ultraviolet ray such as an ArF excimer laser beam or a KrF excimer laser beam, an extreme ultraviolet ray (EUV) or a charged particle ray such as an electron beam, or the like, and a chemical reaction catalyzed by the acid produces a difference in a rate of dissolution in a developer solution between the light-exposed regions and light-unexposed regions, whereby a pattern is formed on a substrate.

Miniaturization in processing techniques has been accompanied by demands for improved resist performances of such radiation-sensitive compositions. To address the demands, types and molecular structures of polymers, acid generating agents and other components to be used in a composition have been studied, and combinations thereof have also been extensively studied (see Japanese Unexamined Patent Application, Publication Nos. H11-125907, H8-146610 and 2000-298347).

Currently, miniaturization of a pattern has proceeded to a level for a line width of no greater than 40 nm, and radiation-sensitive compositions are required to have further improved resist performances, particularly to enable a pattern superior in nanoedge roughness property to be formed with high sensitivity.

### [PRIOR ART DOCUMENTS]

Patent Document 1: Japanese Unexamined Patent Application, Publication No. H11-125907
Patent Document 2: Japanese Unexamined Patent Application, Publication No. H8-146610
Patent Document 3: Japanese Unexamined Patent Application, Publication No. 2000-298347

### [SUMMARY OF THE INVENTION]

### [PROBLEMS TO BE SOLVED BY THE INVENTION]

The present invention was made in view of the foregoing circumstances, and it is an object of the present invention to provide a radiation-sensitive composition and a pattern-forming method that enable a pattern superior in nanoedge roughness property to be formed with high sensitivity.

### [MEANS FOR SOLVING THE PROBLEMS]

According to an aspect of the invention made for solving the aforementioned problems, a radiation-sensitive resin composition comprises: an organic acid (hereinafter, may be also referred to as "(A) organic acid" or "organic acid (A)"); particles comprising a metal oxide as a principal component (hereinafter, may be also referred to as "(B) particles" or "particles (B)"); and an acid generating agent that is capable of generating an acid upon irradiation with a radioactive ray (hereinafter, may be also referred to as "(C) acid generating agent" or "acid generating agent (C)"), wherein the acid generating agent (C) satisfies at least one of the following conditions (i) and (ii):
(i) a pKa that is a logarithmic value of a reciprocal of an acid dissociation constant Ka of the acid generated from the acid generating agent (C) is less than a pKa of the organic acid (A), and a van der Waals volume of the acid is no less than 2.1 x 10⁻²⁸ m³; and
(ii) the acid generating agent (C) comprises a plurality of groups that are capable of generating an acid, and a pKa that is a logarithmic value of a reciprocal of an acid dissociation constant Ka of the acid is less than the pKa of the organic acid.

According to another aspect of the invention made for solving the aforementioned problems, a pattern-forming method comprises: providing a film; exposing the film; and developing the film exposed, wherein the film is provided from the radiation-sensitive composition.

The term "van der Waals volume" as referred to means a volume occupied by a van der Waals sphere on the basis of a van der Waals radius of the atoms constituting the acid generated from the acid generating agent, the volume being calculated by obtaining a stable structure in accordance with the PM3 method using calculation software such as WinMOPAC (Ver. 3.9.0, available from Fujitsu Limited). A "total solid content in the radiation-sensitive composition" as referred to means the sum of the components other than a solvent.

### [EFFECTS OF THE INVENTION]

Due to a combination of: the organic acid; the particles comprising a metal oxide as a principal component; and the acid generating agent that is capable of generating a specific acid, the radiation-sensitive composition and the pattern-forming method according to the aspects of the present invention enable a pattern superior in nanoedge roughness property to be formed with high sensitivity. Therefore, these can be suitably used for a processing process of semiconductor devices and the like, in which further progress of miniaturization is expected in the future.

### [BRIEF DESCRIPTION OF THE DRAWINGS]

FIG. 1 shows a schematic plan view illustrating a line-pattern when seen from above; and
FIG. 2 shows a schematic cross sectional view illustrating a line-pattern configuration.

### [DESCRIPTION OF EMBODIMENTS]

### Radiation-Sensitive Composition

The radiation-sensitive composition contains the organic acid (A), the particles (B) and the acid generating agent (C). The radiation-sensitive composition may also contain a solvent (D) as a favorable component, and may also contain other optional component within a range not leading to impairment of the effects of the present invention. Due to containing the organic acid (A), the particles (B) and the acid generating agent (C), the radiation-sensitive composition enables a pattern superior in nanoedge roughness property to be formed with high sensitivity. Although not necessarily clarified, the reason for achieving the effects described above due to the radiation-sensitive composition having the aforementioned constitution is inferred as in the following, for example. Specifically, it is considered that, in the radiation-sensitive composition, the organic acid (A) is present in the vicinity of the particles (B) due to an interaction with a metal atom or an oxygen atom of the metal oxide in the particles (B), and consequently the particles (B) are highly dispersible in a solvent. Meanwhile, an acid (hereinafter, may be also referred to as "acid (I)") is generated from the acid generating agent (C) upon irradiation with a radioactive ray. Since the pKa of the acid (I) is less than that of the organic acid (A), the acid (I) substitutes the organic acid (A) being present in the vicinity of the particles (B), whereby the acid (I) may be present in the vicinity of the particles (B). Consequently, the particles (B) have reduced dispersibility in an organic solvent due to the small pKa of the acid (I). The van der Waals volume of the acid (I) being no less than the above-specified value, or the acid (I) having a plurality of acid groups enables the dispersibility of the particles (B) in the organic solvent to be further lowered. Therefore, a further improvement of the sensitivity of the radiation-sensitive composition is enabled. In addition, the van der Waals volume of the acid (I) being no less than the above-specified value, or the acid (I) having a plurality of acid groups is considered to result in formation of chelates with the particles (B) or coordination to a plurality of particles (B). Thus, a more appropriate adjustment of the dispersibility of the particles (B) in the solvent of with the acid (I) being present in the vicinity thereof is enabled, and consequently a contrast is expected to be improved. As a result, an improvement of a nanoedge roughness performance of the radiation-sensitive composition is enabled. Hereinafter, each component is explained.

### (A) Organic Acid

The organic acid (A) is an acidic organic compound. The "organic compound" as referred to means a compound having at least one carbon atom. The upper limit of the pKa of the organic acid (A) is preferably 7, more preferably 6, still more preferably 5.5, and particularly preferably 5. The lower limit of the pKa is preferably 0, more preferably 1, still more preferably 1.5, and particularly preferably 3. When the pKa of the organic acid (A) falls within the above range, it is possible to weaken the interaction between the organic acid (A) and the particles (B) in the radiation-sensitive composition, and consequently further improvements of the sensitivity and the nanoedge roughness performance of the radiation-sensitive composition are enabled. Here, in the case of the organic acid (A) being a polyvalent acid, the pKa of the organic acid (A) as referred to means a logarithmic value of a primary acid dissociation constant, i.e., a dissociation constant for dissociation of the first proton. The organic acid (A) may be either a low-molecular weight compound or a high-molecular weight compound, and a low-molecular weight compound is preferred, in light of further weakening the interaction between the organic acid (A) and the particles (B). The upper limit of the molecular weight of the organic acid (A) is preferably 1,000, more preferably 500, still more preferably 400, and particularly preferably 300. The lower limit of the molecular weight of the organic acid (A) is preferably 50. When the molecular weight of the organic acid (A) falls within the above range, it is possible to adjust dispersibility of the particles (B) more appropriately, and consequently further improvements of the sensitivity and the nanoedge roughness performance of the radiation-sensitive composition are enabled.

The organic acid (A) is exemplified by a carboxylic acid, a sulfonic acid, a sulfinic acid, an organic phosphinic acid, an organic phosphonic acid, a phenol, an enol, a thiol, an acid imide, an oxime, a sulfonamide, and the like.

Examples of the carboxylic acid include:
monocarboxylic acids such as formic acid, acetic acid, propionic acid, butanoic acid, pentanoic acid, hexanoic acid, heptanoic acid, octanoic acid, nonanoic acid, decanoic acid, 2-ethylhexanoic acid, oleic acid, acrylic acid, methacrylic acid, trans-2,3-dimethylacrylic acid, stearic acid, linoleic acid, linolenic acid, arachidonic acid, salicylic acid, benzoic acid, p-aminobenzoic acid, monochloroacetic acid, dichloroacetic acid, trichloroacetic acid, trifluoroacetic acid, pentafluoropropionic acid, gallic acid and shikimic acid;
dicarboxylic acids such as oxalic acid, malonic acid, maleic acid, methylmalonic acid, fumaric acid, adipic acid, sebacic acid, phthalic acid and tartaric acid;
carboxylic acids having no less than 3 carboxy groups such as citric acid; and the like.

Examples of the sulfonic acid include benzenesulfonic acid, p-toluenesulfonic acid, and the like.

Examples of the sulfinic acid include benzenesulfinic acid, p-toluenesulfinic acid, and the like.

Examples of the organic phosphinic acid include diethylphosphinic acid, methylphenylphosphinic acid, diphenylphosphinic acid, and the like.

Examples of the organic phosphonic acid include methylphosphonic acid, ethylphosphonic acid, t-butylphosphonic acid, cyclohexylphosphonic acid, phenylphosphonic acid, and the like.

Examples of the phenol include:
monovalent phenols such as phenol, cresol, 2,6-xylenol and naphthol;
divalent phenols such as catechol, resorcinol, hydroquinone and 1,2-naphthalenediol;
phenols having a valency of no less than 3 such as pyrogallol and 2,3,6-naphthalenetriol; and the like.

Examples of the enol include 2-hydroxy-3-methyl-2-butene, 3-hydroxy-4-methyl-3-hexene, and the like.

Examples of the thiol include mercaptoethanol, mercaptopropanol, and the like.

Examples of the acid imide include:
carboxylic imides such as maleimide and succinimide;
sulfonic imides such as a di(trifluoromethanesulfonic acid) imide and di(pentafluoroethanesulfonic acid) imide; and the like.

Examples of the oxime include:
aldoximes such as benzaldoxime and salicylaldoxime;
ketoximes such as diethylketoxime, methylethylketoxime and cyclohexanoneoxime; and the like.

Examples of the sulfonamide include methylsulfonamide, ethylsulfonamide, benzenesulfonamide, toluenesulfonamide, and the like.

In light of further improvements of the sensitivity and the nanoedge roughness performance of the radiation-sensitive composition, as the organic acid (A), the carboxylic acid is preferred; the monocarboxylic acid and the dicarboxylic acid are more preferred; and methacrylic acid, acetic acid, trans-2,3-dimethylacrylic acid, and maleic acid are still more preferred.

The lower limit of the content of the organic acid (A) with respect to the total solid content in the radiation-sensitive composition is preferably 1% by mass, more preferably 5% by mass, and still more preferably 10% by mass. The upper limit of the organic acid (A) is preferably 90% by mass, more preferably 70% by mass, and still more preferably 50% by mass. When the content of the organic acid (A) falls within the above range, further improvements of the sensitivity and the nanoedge roughness performance of the radiation-sensitive composition are enabled. The radiation-sensitive composition may include either only a single type, or two or more types, of the organic acid (A).

### (B) Particles

The particles (B) comprise a metal oxide as a principal component. The term "metal oxide" as referred to means a compound that includes a metal atom and an oxygen atom. The term "principal component" as referred to means a component which is of the highest content among all substances constituting the particles, preferably a component the content of which is no less than 50% by mass, and more preferably a component the content of which is no less than 60% by mass. Due to comprising the metal oxide as a principal component, the particles (B) are capable of absorbing a radioactive ray to generate secondary electrons, by an action of which the acid generating agent (C) may also be decomposed to generate the acid (I), and consequently an improvement of the sensitivity of the radiation-sensitive composition is enabled. Furthermore, due to comprising the metal oxide as a principal component, the particles (B) are capable of improving etching resistance of a pattern formed from the radiation-sensitive composition.

A metal element constituting the metal oxide is exemplified by metal elements from groups 3, 4, 5, 6, 7, 8, 9, 10, 11, 12, 13 and 14. Of these, metal elements from groups 4 to 6, 8 to 10, 13 and 14 are preferred, metal elements from groups 4 to 6 are more preferred, and metal elements from group 4 are still more preferred, in light of further promoting generation of the secondary electrons from the particles (B) and further improving the etching resistance of a film to be provided.

As the metal element, zirconium, hafnium, nickel, cobalt, tin, indium, titanium, ruthenium, tantalum, tungsten and a combination thereof are preferred, and titanium, zirconium and hafnium are more preferred, in light of further promoting generation of the secondary electrons from the particles (B) and further improving the etching resistance of the film to be provided.

The metal oxide may comprise atoms in addition to the metal atom and an oxygen atom, for example a carbon atom, a hydrogen atom, a nitrogen atom, a phosphorus atom, a sulfur atom, a halogen atom, and the like. The lower limit of a total percentage content of the metal atom and the oxygen atom in the metal oxide is preferably 30% by mass, more preferably 50% by mass, still more preferably 70% by mass, and particularly preferably 90% by mass. The upper limit of the total percentage content is typically 100% by mass, and preferably 99.9% by mass. When the total percentage content of the metal atom and the oxygen atom in the metal oxide falls within the above range, the generation of the secondary electrons from the particles (B) is promoted, and consequently a further improvement of the sensitivity of the radiation-sensitive composition is enabled.

The upper limit of the hydrodynamic radius of the particles (B) as determined by the dynamic light scattering analysis is preferably 20 nm, more preferably 17 nm, still more preferably 14 nm, and particularly preferably 10 nm. The lower limit of the hydrodynamic radius is preferably 0.01 nm, more preferably 0.1 nm, still more preferably 0.5 nm, and particularly preferably 1 nm. When the hydrodynamic radius of the particles (B) as determined by the dynamic light scattering analysis falls within the above range, further promotion of the generation of the secondary electrons by the particles (B) is enabled, and consequently the sensitivity and the nanoedge roughness performance of the radiation-sensitive composition can be further improved. It is to be noted that the hydrodynamic radius as determined by the dynamic light scattering analysis can be determined by, for example, measurement (DLS measurement) using a light scattering measurement apparatus ("ALV-5000", available from ALV-GmbH, Germany).

The lower limit of a content of the particles (B) with respect to 100 parts by mass of the organic acid (A) is preferably 10 parts by mass, more preferably 50 parts by mass, still more preferably 80 parts by mass, and particularly preferably 100 parts by mass. The upper limit of the content of the particles (B) is preferably 1,000 parts by mass, more preferably 800 parts by mass, still more preferably 700 parts by mass, and particularly preferably 650 parts by mass.

The lower limit of a content of the particles (B) with respect to the total solid content in the radiation-sensitive composition is preferably 10% by mass, more preferably 30% by mass, and still more preferably 40% by mass. The upper limit of the content of the particles (B) is preferably 95% by mass, more preferably 85% by mass, and still more preferably 80% by mass.

The content of the particles (B) falling within the above ranges leads to further improvements of the sensitivity and the nanoedge roughness performance of the radiation-sensitive composition. The radiation-sensitive composition may include either only a single type, or two or more types, of the particles (B).

### Synthesis Procedure of (B) Particles

The particles (B) may be synthesized by using, for example, a (a) metal-containing compound (described later; may be also referred to as "metal-containing compound (a)"), through a procedure of carrying out a hydrolytic condensation reaction of the metal-containing compound (a), a procedure of carrying out a substitution reaction of a ligand etc. of the metal-containing compound (a), and the like, for example. The "hydrolytic condensation reaction" as referred to means a reaction in which a hydrolyzable group comprised in the metal-containing compound (a) is hydrolyzed by an action of water to give -OH, and a water molecule is eliminated from two -OHs thus generated, causing condensation to form -O-. The organic acid (A) may be added upon the reaction for synthesizing the particles (B) from the metal-containing compound (a). Due to adding the organic acid (A) upon formation of the particles (B), the particles (B) containing the organic acid (A) (hereinafter, may be also referred to as "(X) organic acid-containing particles" or "organic acid-containing particles (X)") can be obtained.

### (a) Metal-Containing Compound

The metal-containing compound (a) is: a metal compound (I) having a hydrolyzable group; a hydrolysis product of the metal compound (I) having a hydrolyzable group; a hydrolytic condensation product of the metal compound (I) having a hydrolyzable group; or a combination thereof.

The hydrolyzable group is exemplified by a halogen atom, an alkoxy group, a carboxylate group, and the like.

Examples of the halogen atom include a fluorine atom, a chlorine atom, a bromine atom, an iodine atom, and the like.

Examples of the alkoxy group include a methoxy group, an ethoxy group, a n-propoxy group, an i-propoxybutoxy group, and the like.

Examples of the carboxylate group include a formate group, an acetate group, a propionate group, a butyrate group, a stearate group, a benzoate group, an oxalate group, a (meth)acrylate group, and the like.

As the hydrolyzable group, the alkoxy group and the carboxylate group are preferred, and an isopropoxy group, a butoxy group and a stearate group are more preferred.

The metal compound (I) may be used either alone of one type, or in combination of two or more types thereof. In a case in which the metal-containing compound (a) is a hydrolytic condensation product of the metal compound (I), the metal compound (I) may have been hydrolytically condensed with a compound having a hydrolyzable group comprising a metalloid element other than the metal, within a range not leading to impairment of the effects of the embodiments of the present invention. Therefore, the hydrolytic condensation product of the metal compound (I) may also comprise the metalloid element, within a range not leading to impairment of the effects of the embodiments of the present invention. The metalloid element is exemplified by a boron atom, a silicon atom, and the like. The upper limit of a content of the metalloid element is preferably 50 atomic %, more preferably 30 atomic %, and still more preferably 10 atomic % with respect to a total of the metal element and the metalloid element in the hydrolytic condensation product.

The metal compound (I) is exemplified by compounds represented by the following formula (1) (hereinafter, may be also referred to as a "metal compound (I-1)"), and the like. Hydrolytic condensation of such a metal compound results in bridging between the metal atoms via -O-, thereby enabling the metal oxide to be stably formed. Consequently, further improvements of the sensitivity and the nanoedge roughness performance of the radiation-sensitive composition are enabled.

LₐMY_{b} (1)

In the above formula (1): M represents a metal element; L represents a ligand; a is an integer of 0 to 2, wherein in a case where a is 2, a plurality of Ls may be identical or different; Y represents a hydrolyzable group selected from a halogen atom, an alkoxy group, and a carboxylate group; and b is an integer of 2 to 6, wherein a plurality of Ys may be identical or different. L represents a ligand that does not fall under the definition of Y.

The metal element represented by M is exemplified by metal elements from groups 3, 4, 5, 6, 7, 8, 9, 10, 11, 12, 13, and 14, and the like. Of these, the metal elements from the groups 4 to 6, 8 to 10, 13 and 14 are preferred, and zirconium, hafnium, nickel, cobalt, tin, indium, titanium, ruthenium, tungsten and a combination thereof are more preferred.

The ligand represented by L is exemplified by a monodentate ligand and a polydentate ligand.

Exemplary monodentate ligand includes a hydroxo ligand, a carboxy ligand, an amido ligand, and the like.

Examples of the amido ligand include an unsubstituted amido ligand (NH₂), a methylamido ligand (NHMe), a dimethylamido ligand (NMe₂), a diethylamido ligand (NEt₂), a dipropylamido ligand (NPr₂), and the like.

Exemplary polydentate ligand includes a hydroxy acid ester, a β-diketone, a β-keto ester, a β-dicarboxylic acid ester, a hydrocarbon having a π bond, a diphosphine, ammonia, and the like.

Examples of the hydroxy acid ester include glycolic acid esters, lactic acid esters, 2-hydroxycyclohexane-1-carboxylic acid esters, salicylic acid esters, and the like.

Examples of the β-diketone include 2,4-pentanedione, 3-methyl-2,4-pentanedione, 3-ethyl-2,4-pentanedione, and the like.

Examples of the β-keto ester include acetoacetic acid esters, α-alkyl-substituted acetoacetic acid esters, β-ketopentanoic acid esters, benzoylacetic acid esters, 1,3-acetonedicarboxylic acid esters, and the like.

Examples of the β-dicarboxylic acid ester include malonic acid diesters, α-alkyl-substituted malonic acid diesters, α-cycloalkyl-substituted malonic acid diesters, α-aryl-substituted malonic acid diesters, and the like.

Examples of the hydrocarbon having a π bond include:
chain olefins such as ethylene and propylene;
cyclic olefins such as cyclopentene, cyclohexene and norbornene;
chain dienes such as butadiene and isoprene;
cyclic dienes such as cyclopentadiene, methylcyclopentadiene, pentamethylcyclopentadiene, cyclohexadiene and norbornadiene;
aromatic hydrocarbons such as benzene, toluene, xylene, hexamethylbenzene, naphthalene and indene; and the like.

Examples of the diphosphine include 1,1-bis(diphenylphosphino)methane, 1,2-bis(diphenylphosphino)ethane, 1,3-bis(diphenylphosphino)propane, 2,2'-bis(diphenylphosphino)-1,1'-binaphthyl, 1,1'-bis(diphenylphosphino)ferrocene, and the like.

Examples of the halogen atom which may be represented by Y include a fluorine atom, a chlorine atom, a bromine atom, an iodine atom, and the like.

Examples of the alkoxy group which may be represented by Y include a methoxy group, an ethoxy group, a propoxy group, a butoxy group, and the like.

Examples of the carboxylate group which may be represented by Y include a formate group, an acetate group, a propionate group, a butyrate group, a valerate group, a stearate group, and the like.

Y represents preferably an alkoxy group or a carboxylate group, and more preferably an isopropoxy group, a butoxy group or a stearate group.

Preferably, b is 4. When b is the above specified value, it is possible to increase the percentage content of the metal oxide in the particles (B), and thus promotion of the generation of the secondary electrons by the particles (B) is enabled. Consequently, a further improvement of the sensitivity of the radiation-sensitive composition is enabled.

As the metal-containing compound (a), a metal alkoxide that is neither hydrolyzed nor hydrolytically condensed is preferred.

Examples of the metal-containing compound (a) include zirconium tetra-n-butoxide, zirconium tetra-n-propoxide, hafnium tetraethoxide, hafnium tetraisopropoxide, tantalum pentaethoxide, tungsten pentamethoxide, tungsten hexaethoxide, iron chloride, titanium tetra-n-butoxide, titanium tetra-n-propoxide, zirconium di-n-butoxide bis(2,4-pentanedionate), titanium tri-n-butoxide stearate, bis(cyclopentadienyl)hafnium dichloride, bis(cyclopentadienyl)tungsten dichloride, diacetato[(S)-(-)-2,2'-bis(diphenylphosphino)-1,1'-binaphtyl]ruthenium, dichloro[ethylenebis(diphenylphosphine)]cobalt, a titanium butoxide oligomer, aminopropyltrimethoxytitanium, aminopropyltriethoxyzirconium, 2-(3,4-epoxycyclohexyl)ethyltrimethoxyzirconium, γ-glycidoxypropyltrimethoxyzirconium, 3-isocyanopropyltrimethoxyzirconium, 3-isocyanopropyltriethoxyzirconium, triethoxymono(acetylacetonato)titanium, tri-n-propoxymono(acetylacetonato)titanium, tri-i-propoxymono(acetylacetonato)titanium, triethoxymono(acetylacetonato)zirconium, tri-n-propoxymono(acetylacetonato)zirconium, tri-i-propoxymono(acetylacetonato)zirconium, diisopropoxybis(acetylacetonato)titanium, di-n-butoxybis(acetylacetonato)titanium, di-n-butoxybis(acetylacetonato)zirconium, tri(3-methacryloxypropyl)methoxyzirconium, tri(3-acryloxypropyl)methoxyzirconium, and the like. Of these, titanium tri-n-butoxide stearate, zirconium tetra-n-butoxide, zirconium tetra-n-propoxide and hafnium tetraisopropoxide are preferred.

Upon the synthesis reaction of the particles (B), in addition to the metal compound (I) and the organic acid (A), a compound that may be the polydentate ligand represented by L in the compound of the formula (1), a compound that may be a bridging ligand, etc., may also be added. The compound that may be a bridging ligand is exemplified by compounds each having a plurality of hydroxy groups, isocyanate groups, amino groups, ester groups or amide groups, and the like.

The synthesis reaction of the particles (B) may be carried out, for example, in a solvent. The hydrolytic condensation reaction of the metal-containing compound (a), etc. may be carried out, for example, in a water-containing solvent. The lower limit of the amount of water used for the hydrolytic condensation reaction is preferably 0.2 times molar amount, more preferably an equimolar amount, and still more preferably 3 times molar amount with respect to the hydrolyzable group comprised in the metal-containing compound (a) and the like. The upper limit of the amount of water is preferably 20 times molar amount, more preferably 15 times molar amount, and still more preferably 10 times molar amount. When the amount of the water in the hydrolytic condensation reaction falls within the above range, it is possible to increase the percentage content of the metal oxide in the particles (B) to be obtained, and consequently further improvements of the sensitivity and the nanoedge roughness performance of the radiation-sensitive composition are enabled.

The solvent for use in the synthesis reaction of the particles (B) is not particularly limited, and solvents similar to those exemplified in connection with the solvent (D) described later may be used. Of these, an alcohol solvent, an ether solvent, an ester solvent and a hydrocarbon solvent are preferred; an alcohol solvent and an ester solvent are more preferred; a polyhydric alcohol partially etherated solvent, a monocarboxylic acid ester solvent and a polyhydric alcohol partially etherated carboxylate solvent are still more preferred; and propylene glycol monomethyl ether, ethyl lactate and propylene glycol monoethyl ether acetate are particularly preferred.

After the completion of the synthesis reaction of the particles (B), the solvent used in the reaction may be directly used as the solvent (D) in the radiation-sensitive composition without removal thereof.

The lower limit of the temperature of the synthesis reaction of the particles (B) is preferably 0 °C, and more preferably 10 °C. The upper limit of the temperature is preferably 150 °C, and more preferably 100 °C.

The lower limit of the time period of the synthesis reaction of the particles (B) is preferably 1 min, and more preferably 10 min. The upper limit of the time period is preferably 100 hrs, and more preferably 50 hrs.

### (C) Acid Generating Agent

The acid generating agent (C) is capable of generating the acid (I) upon irradiation with the radioactive ray, and satisfies at least one of the following conditions (i) and (ii) (the acid generating agent (C) being also referred to as "acid generating agent (C1)" and "acid generating agent (C2)" that satisfy the following conditions (i) and (ii), respectively):
(i) a pKa that is a logarithmic value of a reciprocal of an acid dissociation constant Ka of the acid generated from the acid generating agent (C) is less than a pKa of the organic acid (A), and a van der Waals volume of the acid is no less than 2.1 x 10⁻²⁸ m³; and
(ii) the acid generating agent (C) has a plurality of groups that are capable of generating an acid, and a pKa that is a logarithmic value of a reciprocal of an acid dissociation constant Ka of the acid is less than the pKa of the organic acid (A).

Examples of the radioactive ray include: electromagnetic waves such as ultraviolet rays, visible light rays, far ultraviolet rays, X-rays and γ-rays; charged particle rays such as electron beams and α-rays; and the like. Hereinafter, the acid generating agent (C1) and the acid generating agent (C2) are explained.

### Acid Generating Agent (C1)

The acid generating agent (C1) is capable of generating an acid having a pKa less than the pKa of the organic acid (A), and a van der Waals volume of no less than 2.1 x 10⁻²⁸ m³.

The upper limit of the pKa of the acid (I) generated from the acid generating agent (C1) is preferably 3, more preferably 0, still more preferably -1, and particularly preferably -2. The lower limit of the pKa is preferably -10, more preferably -8, still more preferably -6, and particularly preferably -5. When the pKa of the acid (I) falls within the above range, it is possible to further reduce the dispersibility of the particles (B) in a solvent, and consequently a further improvement of the sensitivity of the radiation-sensitive composition is enabled. It is to be noted that the pKa of the acid is determined, for example, in water at 25 °C.

The lower limit of the van der Waals volume of the acid (I) generated from the acid generating agent (C1) is preferably 2.5 x 10⁻²⁸ m³, more preferably 2.8 x 10⁻²⁸ m³, still more preferably 3.1 x 10⁻²⁸ m³, and particularly preferably 3.4 x 10⁻²⁸ m³. The upper limit of the aforementioned van der Waals volume is preferably 20 x 10⁻²⁸ m³, more preferably 10 x 10⁻²⁸ m³, still more preferably 8 x 10⁻²⁸ m³, and particularly preferably 5 x 10⁻²⁸ m³. When the van der Waals volume of the acid (I) falls within the above range, a more appropriate adjustment of the dispersibility of the particles (B) in a solvent with the acid (I) being present in the vicinity thereof is enabled, and consequently further improvements of the sensitivity and the nanoedge roughness performance of the radiation-sensitive composition are enabled.

The acid generating agent (C) is exemplified by an onium salt compound, a N-sulfonyloxyimide compound, a halogen-containing compound, a diazo ketone compound, and the like. Of these acid generating agents (C), an onium salt compound is preferred.

Exemplary onium salt compound includes a sulfonium salt, a tetrahydrothiophenium salt, an iodonium salt, a phosphonium salt, a diazonium salt, a pyridinium salt, and the like.

Examples of the sulfonium salt include triphenylsulfonium perfluoro-n-octanesulfonate, triphenylsulfonium 2-bicycle[2.2.1]hept-2-yl-1,1,2,2,-tetrafluoroethanesulfonate, triphenylsulfonium camphorsulfonate, triphenylsulfonium 6-(1-adamantan-1-ylcarbonyloxy)-1,1,2,2-tetrafluorohexane-1-sulfonate, triphenylsulfonium 2-(1-adamantyl)-1,1-difluoroethanesulfonate, triphenylsulfonium 2-(adamantan-1-ylcarbonyloxy)-1,1,3,3,3-pentafluoropropane-1-sulfonate, triphenylsulfonium 2-(4-oxoadamantan-1-ylcarbonyloxy)-1,1,3,3,3-pentafluoropropane-1-silfonate, triphenylsulfonium 1,2-di(cyclohexyloxycarbonyl)ethane-1-sulfonate, 4-cyclohexylphenyldiphenylsulfonium perfluoro-n-octanesulfonate, 4-cyclohexylphenyldiphenylsulfonium 2-bicycle[2.2.1]hept-2-yl-1,1,2,2-tetrafluoroethanesulfonate, 4-cyclohexylphenyldiphenylsulfonium camphorsulfonate, 4-methanesulfonylphenyldiphenylsulfonium perfluoro-n-octanesulfonate, 4-methanesulfonylphenyldiphenylsulfonium 2-bicyclo[2.2.1]hept-2-yl-1,1,2,2-tetrafluoroethanesulfonate, 4-methanesulfonylphenyldiphenylsulfonium camphorsulfonate, 4-cyclohexylsulfonylphenyldiphenylsulfonium 5,6-di(cyclohexyloxycarbonyl)norbornane-2-sulfonate, and the like.

Examples of the tetrahydrothiophenium salt include 1-(4-n-butoxynaphthalen-1-yl)tetrahydrothiophenium perfluoro-n-octanesulfonate, 1-(4-n-butoxynaphthalen-1-yl)tetrahydrothiophenium 2-bicyclo[2.2.1]hept-2-yl-1,1,2,2-tetrafluoroethanesulfonate, 1-(4-n-butoxynaphthalen-1-yl)tetrahydrothiophenium camphorsulphonate, 1-(4-n-butoxynaphthalen-1-yl)tetrahydrothiophenium hexafluoropropylene sulfonimide, 1-(6-n-butoxynaphthalen-2-yl)tetrahydrothiophenium perfluoro-n-octanesulfonate, 1-(6-n-butoxynaphthalen-2-yl)tetrahydrothiophenium 2-bicyclo[2.2.1]hept-2-yl-1,1,2,2-tetrafluoroethanesulfonate, 1-(6-n-butoxynaphthalen-2-yl)tetrahydrothiophenium camphorsulphonate, 1-(6-n-butoxynaphthalen-2-yl)tetrahydrothiophenium hexafluoropropylene sulfonimide, 1-(3,5-dimethyl-4-hydroxyphenyl)tetrahydrothiophenium perfluoro-n-octanesulfonate, 1-(3,5-dimethyl-4-hydroxyphenyl)tetrahydrothiophenium 2-bicyclo[2.2.1]hept-2-yl-1,1,2,2-tetrafluoroethanesulfonate, 1-(3,5-dimethyl-4-hydroxyphenyl)tetrahydrothiophenium camphorsulfonate, 1-(3,5-dimethyl-4-hydroxyphenyl)tetrahydrothiophenium tetrahydrothiophenium hexafluoro propylene sulfonimide, and the like.

Examples of the iodonium salt include diphenyliodonium perfluoro-n-octanesulfonate, diphenyliodonium 2-bicyclo[2.2.1]hept-2-yl-1,1,2,2-tetrafluoroethanesulfonate, diphenyliodonium camphorsulfonate, bis(4-t-butylphenyl)iodonium perfluoro-n-octanesulfonate, bis(4-t-butylphenyl)iodonium 2-bicyclo[2.2.1]hept-2-yl-1,1,2,2-tetrafluoroethanesulfonate, bis(4-t-butylphenyl)iodonium camphorsulfonate, and the like.

Examples of the N-sulfonyloxyimide compound include N-(trifluoromethanesulfonyloxy)bicyclo[2.2.1]hept-5-ene-2,3-dicarboxyimide, N-(nonafluoro-n-butanesulfonyloxy)bicyclo[2.2.1]hept-5-ene-2,3-dicarboxyimide, N-(perfluoro-n-octanesulfonyloxy)bicyclo[2.2.1]hept-5-ene-2,3-dicarboxyimide, N-(2-bicyclo[2.2.1]hept-2-yl-1,1,2,2-tetrafluoroethanesulfonyloxy)bicyclo[2.2.1]hept-5-ene-2,3-dicarboxyimide, N-(2-(3-tetracyclo[4.4.0.1^{2,5}.1^{7,10}]dodecanyl)-1,1-difluoroethanesulfonyloxy)bicyclo[2.2 .1]hept-5-ene-2,3-dicarboxyimide, N-(camphorsulfonyloxy)bicyclo[2.2.1]hept-5-ene-2,3-dicarboxyimide, and the like.

Of these, as the acid generating agent (C1), the onium salt is preferred, the sulfonium salt is more preferred, and the triphenylsulfonium salt is still more preferred.

In light of availability of the acid generating agent (C1), the acid (I) generated from the acid generating agent (C1) is preferably a compound having one acid group, more preferably a compound having one sulfo group, and still more preferably 2-(4-oxoadamantan-1-ylcarbonyloxy)-1,1,3,3,3-pentafluoropropane-1-sulfonic acid, 5,6-di(cyclohexyloxycarbonyl)norbornane-2-sulfonic acid, 1,2-di(cyclohexyloxycarbonyl)ethane-1-sulfonic acid, and 6-(adamantan-1-ylcarbonyloxy)hexane-1,1,2,2-tetrafluorobutane-1-sulfonic acid.

### (C2) Acid Generating Agent

The acid generating agent (C2) has a plurality of groups that are capable of generating an acid, the acid having a pKa for an acid dissociation constant less than the pKa of the organic acid (A).

The acid generating group included in the acid generating agent (C2) is exemplified by: protected sulfo groups such as a sulfonate group, a phosphonate group, a carboxylate group, a phenolate group and a N-sulfonyloxy group; and the like. Examples of a protecting group of the sulfo groups include a 5-norbornene-2,3-dicarboxyimide group, a 4-methoxyphenyl-trifluoromethyl ketoimino group, a 2-nitro-6-trifluoromethyl benzyl group, and the like. Of these, from the perspective that generation of the acid (I) having a lower pKa is enabled, the sulfonate group, the phosphonate group and the protected sulfo group are preferred, the sulfonate group and the protected sulfo group are more preferred, the sulfonate group and the N-sulfonyloxy group are still more preferred, and the sulfonate group is particularly preferred. The plurality of acid generating groups included in the acid generating agent (C2) may be identical or different.

The acid group included in the acid (I) generated from the acid generating agent (C2) is exemplified by a sulfo group, a phosphoric acid group, a phosphono group, a carboxy group, a phenolic hydroxyl group, and the like. Of these, from the perspective that further lowering of the pKa of the acid (I) is enabled, a sulfo group and a phosphoric acid group are preferred, and a sulfo group is more preferred. The plurality of acid groups included in the acid (I) may be identical or different.

The lower limit of the number of the acid generating groups included in the acid generating agent (C2) is 2. The upper limit of the number is preferably 10, more preferably 5, and still more preferably 3.

The upper limit of the pKa of the acid (I) generated from the acid generating agent (C2) is preferably 3, more preferably 0, still more preferably -1, and particularly preferably -2. The lower limit of the pKa is preferably -10, more preferably -8, still more preferably -6, and particularly preferably -5. When the pKa of the acid (I) falls within the above range, it is possible to further reduce the dispersibility of the particles (B) in a solvent, and consequently a further improvement of the sensitivity of the radiation-sensitive composition is enabled. It is to be noted that the pKa of the acid generated from the acid generating agent (C2) is determined on the basis of a first acid dissociation constant of the acid (I), i.e., determined for dissociation of the first proton among the plurality of protons that are going to dissociate from the acid (I). The pKa of the acid is determined, for example, in water at 25 °C.

The acid generating agent (C2) is exemplified by an onium salt compound, an N-sulfonyloxyimide compound, a compound having a protected sulfo group, a halogen-containing compound, a diazo ketone compound, and the like. Of these acid generating agents (C2), the onium salt compound is preferred. The onium salt compound typically includes a radiation-sensitive onium cation and an anion having a plurality of acid generating groups, in which the radiation-sensitive onium cation is to be decomposed to generate a proton by action(s) of the radioactive ray and/or the secondary electrons, etc. generated by the particles (B) upon the irradiation with the radioactive ray, leading to generation of the acid (acid group) by an action of the proton.

Exemplary onium salt compound includes a sulfonium salt, an iodonium salt, a phosphonium salt, a diazonium salt, a pyridinium salt, and the like.

Examples of the sulfonium salt include a tri-aromatic group-containing sulfonium salt, a dialkyl group-containing sulfonium salt, a tetrahydrothiophenium salt, and the like.

The tri-aromatic group-containing sulfonium salt may be, for example, any one of compounds represented by the following formulae (i-1) to (i-15) and the like.

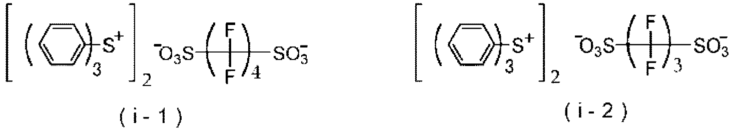

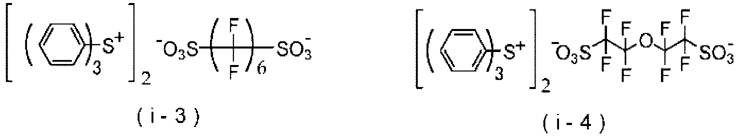

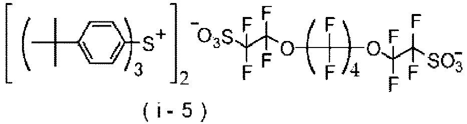

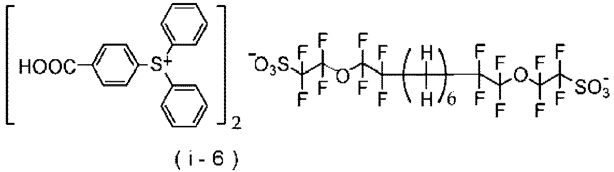

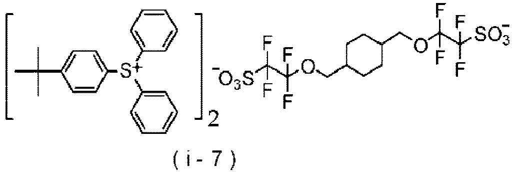

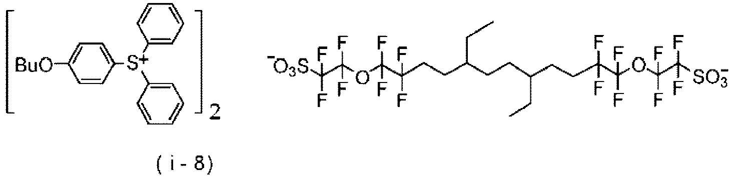

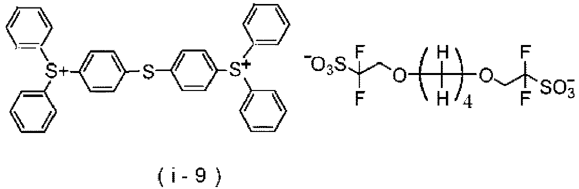

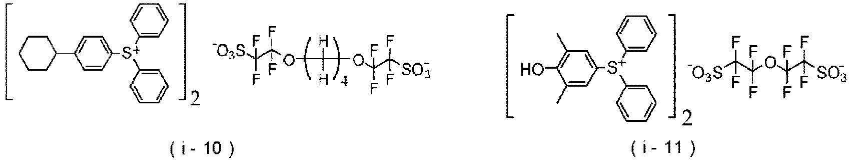

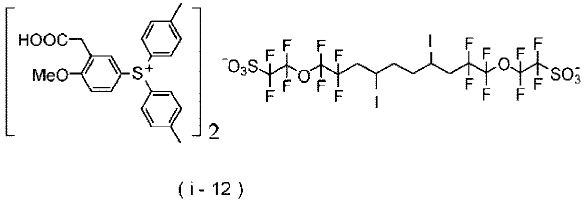

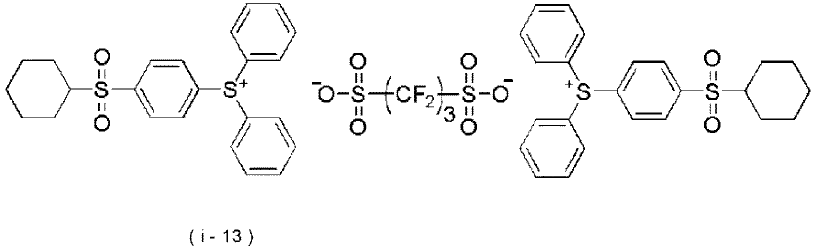

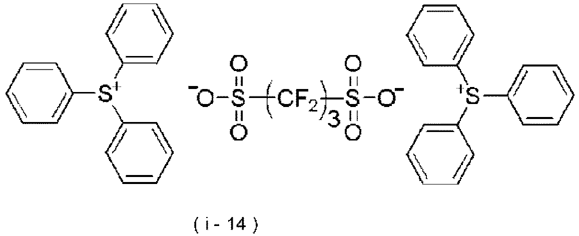

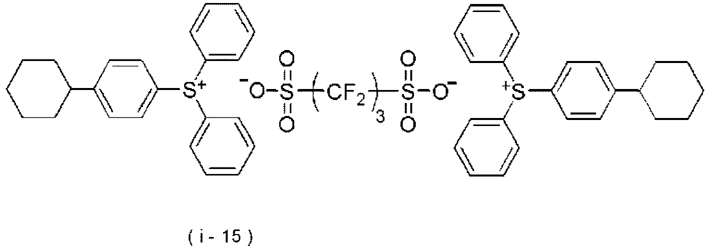

The dialkyl group-containing sulfonium salt and the tetrahydrothiophenium salt may be, for example, any one of compounds represented by the following formulae (ii-1) to (ii-11) and the like.

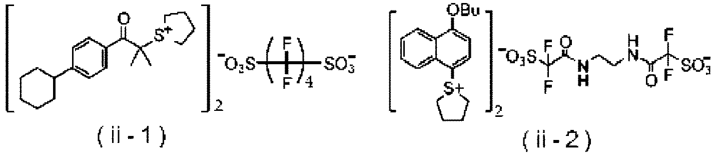

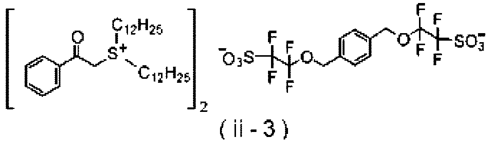

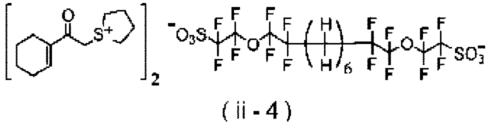

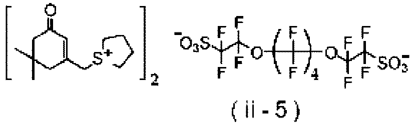

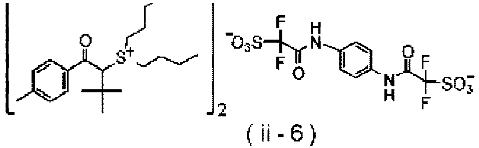

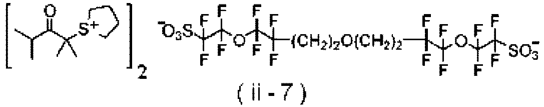

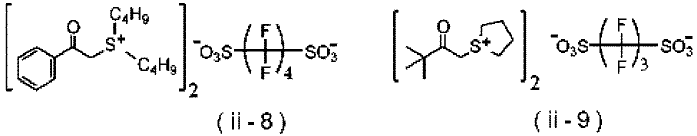

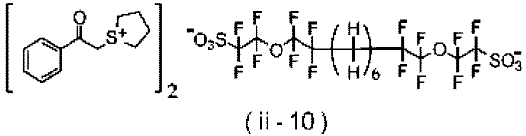

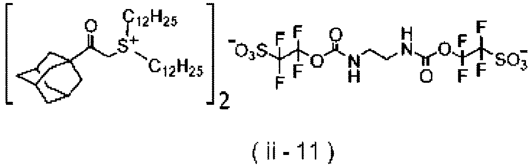

Examples of the iodonium salt include a compound represented by the following formula (iii-1), a compound represented by the following formula (iii-2), and the like.

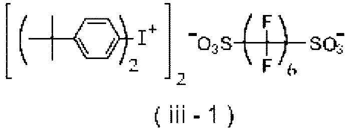

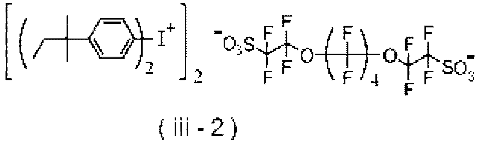

Exemplary compound having a protected sulfo group includes compounds represented by the following formulae (iv-1) to (iv-4), and the like.

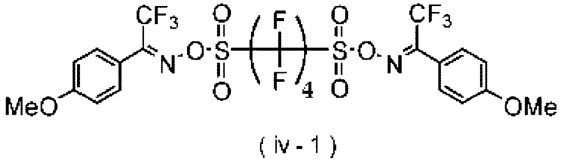

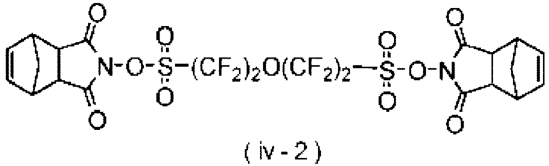

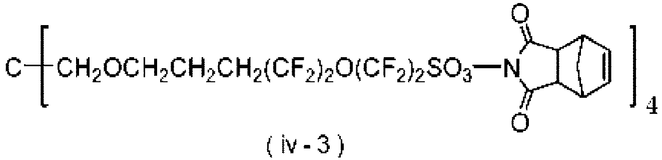

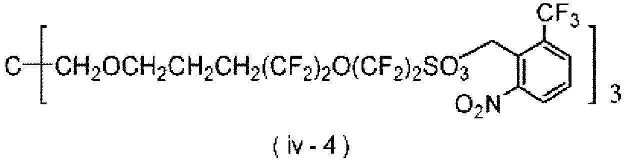

Of these, as the acid generating agent (C2), the onium salt is preferred, the sulfonium salt is more preferred, the tri-aromatic group-containing sulfonium salt is still more preferred, and a triphenylsulfonium salt and a cycloalkylsulfonylphenyldiphenylsulfonium salt are particularly preferred.

As the acid generating agent (C2), a compound having two acid groups is preferred, and cyclohexane-1,4-di(methyleneoxy-tetrafluoroethanesulfonic acid) and 1,1,2,2,3,3-hexafluoropropane-1,3-disulfonic acid are more preferred.

As the acid generating agent (C), di(triphenylsulfonium) cyclohexane-1,4-di(methyleneoxy-tetrafluoroethanesulfonate) and di(4-cyclohexylsulfonylphenyldiphenyl sulfonium) 1,1,2,2,3,3-hexafluoropropane-1,3-disulfonate are preferred.

The lower limit of a content of the acid generating agent (C) with respect to 100 parts by mass of the organic acid (A) is preferably 1 part by mass, more preferably 10 parts by mass, and still more preferably 20 parts by mass. The upper limit of the content of the acid generating agent (C) is preferably 1,000 parts by mass, more preferably 500 parts by mass, and still more preferably 200 parts by mass.

The lower limit of a content of the acid generating agent (C) with respect to the total solid content in the radiation-sensitive composition is preferably 1% by mass, more preferably 5% by mass, and still more preferably 10% by mass. The upper limit of the content of the acid generating agent (C) is preferably 50% by mass, more preferably 40% by mass, and still more preferably 30% by mass.

The content of the acid generating agent (C) falling within the above ranges leads to further improvements of the sensitivity and the nanoedge roughness performance of the radiation-sensitive composition. The radiation-sensitive composition may include either only a single type, or two or more types, of the acid generating agent (C).

### (D) Solvent

The radiation-sensitive composition typically contains the solvent (D). The solvent (D) is not particularly limited as long as it is a solvent capable of dissolving or dispersing at least the organic acid (A), the particles (B) and the acid generating agent (C), as well as optional component(s) contained as needed. The solvent used in the synthesis reaction of the particles (B) or the like may also be directly used as the solvent (D). The radiation-sensitive composition may include either only a single type, or two or more types, of the solvent (D).

The solvent (D) is exemplified by an alcohol solvent, an ether solvent, a ketone solvent, an amide solvent, an ester solvent, a hydrocarbon solvent, and the like.

Examples of the alcohol solvent include:
aliphatic monohydric alcohol solvents having 1 to 18 carbon atoms such as 4-methyl-2-pentanol and n-hexanol;
alicyclic monohydric alcohol solvents having 3 to 18 carbon atoms such as cyclohexanol;
polyhydric alcohol solvents having 2 to 18 carbon atoms such as 1,2-propylene glycol;
polyhydric alcohol partially etherated solvents having 3 to 19 carbon atoms such as propylene glycol monomethyl ether; and the like.

Examples of the ether solvent include:
dialkyl ether solvents such as diethyl ether, dipropyl ether, dibutyl ether, dipentyl ether, diisoamyl ether, dihexyl ether and diheptyl ether;
cyclic ether solvents such as tetrahydrofuran and tetrahydropyran;
aromatic ring-containing ether solvents such as diphenyl ether and anisole; and the like.

Examples of the ketone solvent include:
chain ketone solvents such as acetone, methyl ethyl ketone, methyl n-propyl ketone, methyl n-butyl ketone, diethyl ketone, methyl iso-butyl ketone, 2-heptanone, ethyl n-butyl ketone, methyl n-hexyl ketone, di-iso-butyl ketone and trimethylnonanone;
cyclic ketone solvents such as cyclopentanone, cyclohexanone, cycloheptanone, cyclooctanone and methylcyclohexanone;
2,4-pentanedione, acetonylacetone and acetophenone; and the like.

Examples of the amide solvent include:
cyclic amide solvents such as N,N'-dimethylimidazolidinone and N-methylpyrrolidone;
chain amide solvents such as N-methylformamide, N,N-dimethylformamide, N,N-diethylformamide, acetamide, N-methylacetamide, N,N-dimethylacetamide and N-methylpropionamide; and the like.

Examples of the ester solvent include:
monocarboxylic acid ester solvents such as n-butyl acetate and ethyl lactate;
polyhydric alcohol carboxylate solvents such as propylene glycol acetate;
polyhydric alcohol partially etherated carboxylate solvents such as propylene glycol monoethyl ether acetate;
polyhydric carboxylic acid diester solvents such as diethyl oxalate;
lactone solvents such as γ-butyrolactone and δ-valerolactone;
carbonate solvents such as dimethyl carbonate, diethyl carbonate, ethylene carbonate and propylene carbonate; and the like.

Examples of the hydrocarbon solvent include:
aliphatic hydrocarbon solvents having 5 to 12 carbon atoms such as n-pentane and n-hexane;
aromatic hydrocarbon solvents having 6 to 16 carbon atoms such as toluene and xylene; and the like.

As the solvent (D), the ester solvent is preferred; the polyhydric alcohol partially etherated carboxylate solvents and the monocarboxylic acid ester solvents are preferred; and propylene glycol monomethyl ether acetate and ethyl lactate are still more preferred.

### Other Optional Component

The radiation-sensitive composition may also contain, in addition to the components (A) to (D), optional components such as a compound that may be a ligand, a surfactant, and the like.

### Compound that may be Polydentate Ligand or Bridging Ligand

The radiation-sensitive composition may contain a compound that may be a polydentate ligand or a bridging ligand (hereinafter, may be also referred to as "compound (II)"). Examples of the compound that may be a polydentate ligand or a bridging ligand include compounds exemplified as the compounds that may be added upon the hydrolytic condensation reaction, and the like.

The lower limit of a content of the compound (II) with respect to 100 parts by mass of the organic acid (A) is preferably 10 parts by mass, more preferably 3 parts by mass, and still more preferably 1 part by mass.

The upper limit of a content of the compound (II) with respect to the total solid content in the radiation-sensitive composition is preferably 10% by mass, more preferably 3% by mass, and still more preferably 1% by mass.

### Surfactant

The surfactant exhibits the effect of improving coating properties, striation and the like. Examples of the surfactant include: nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate and polyethylene glycol distearate. Also, examples of commercially available product of the surfactant include KP341 (Shin-Etsu Chemical Co., Ltd.), Polyflow No. 75 and Polyflow No. 95 (each available from Kyoeisha Chemical Co., Ltd.), EFTOP EF301, EFTOP EF303 and EFTOP EF352 (each available from Tochem Products Co. Ltd.), Megaface F171 and Megaface F173 (each available from DIC Corporation), Fluorad FC430 and Fluorad FC431 (each available from Sumitomo 3M Limited), ASAHI GUARD AG710, Surflon S-382, Surflon SC-101, Surflon SC-102, Surflon SC-103, Surflon SC-104, Surflon SC-105 and Surflon SC-106 (each available from Asahi Glass Co., Ltd.), and the like.

### Preparation Method of Radiation-Sensitive Composition

The radiation-sensitive composition may be prepared, for example, by mixing the organic acid (A), the particles (B) and the acid generating agent (C), as well as the other optional component(s) and the solvent (D) as needed, at a certain ratio, preferably followed by filtering the mixture thus obtained through a membrane filter having a pore size of about 0.2 µm. The lower limit of a solid content concentration of the radiation-sensitive composition is preferably 0.1% by mass, more preferably 0.5% by mass, still more preferably 1% by mass, and particularly preferably 1.5% by mass. The upper limit of the solid content concentration of the radiation-sensitive composition is preferably 50% by mass, more preferably 30% by mass, still more preferably 10% by mass, and particularly preferably 5% by mass.

### Pattern-Forming Method

The pattern-forming method comprises: providing a film (hereinafter, may be also referred to as "film-providing step"); exposing the film (hereinafter, may be also referred to as "exposure step"); and developing the film exposed (hereinafter, may be also referred to as "development step"). In the pattern-forming method, the film is provided from the radiation-sensitive composition. Since the radiation-sensitive composition described above is used, the pattern-forming method enables a pattern superior in nanoedge roughness property to be formed with high sensitivity. Hereinafter, each step is explained.

### Film-Providing Step

In this step, a film is provided by using the radiation-sensitive composition. The film may be provided by, for example, applying the radiation-sensitive composition on a substrate. An application procedure is not particularly limited, and an appropriate application procedure such as spin-coating, cast coating and roller coating may be employed. Examples of the substrate include a silicon wafer, a wafer coated with aluminum, and the like. Specifically, applying the radiation-sensitive composition such that a resulting film has a predetermined thickness is followed by prebaking (PB) to evaporate a solvent in the coating film as needed.

The lower limit of an average thickness of the film is preferably 1 nm, more preferably 5 nm, still more preferably 10 nm, and particularly preferably 20 nm. The upper limit of the average thickness of the film is preferably 1,000 nm, more preferably 200 nm, still more preferably 100 nm, and particularly preferably 50 nm.

The lower limit of a temperature for the PB is typically 60 °C, and preferably 80 °C. The upper limit of the temperature for the PB is typically 140 °C, and preferably 120 °C. The lower limit of a time period of the PB is typically 5 sec, and preferably 10 sec. The upper limit of the time period of the PB is typically 600 sec, and preferably 300 sec.

### Exposure Step

In this step, the film provided in the film-providing step is exposed. The exposure is carried out by irradiating with a radioactive ray through a mask having a predetermined pattern, and through a liquid immersion medium such as water as needed. Examples of the radioactive ray include: electromagnetic waves such as visible light rays, ultraviolet rays, far ultraviolet rays, extreme ultraviolet rays (EUV, wavelength: 13.5 nm), X-rays and γ-rays; charged particle rays such as electron beams and α-rays; and the like. Of these, radioactive rays that cause the particles (B) to release more secondary electrons upon an exposure are preferred, and EUV and the electron beams are more preferred.

Subsequent to the exposure, post exposure baking (PEB) may be carried out. The lower limit of a temperature for the PEB is typically 50 °C, and preferably 80 °C. The upper limit of the temperature for the PEB is typically 180 °C, and preferably 130 °C. The lower limit of a time period of the PEB is typically 5 sec, and preferably 10 sec. The upper limit of the time period of the PEB is typically 600 sec, and preferably 300 sec.

In the embodiment of the present invention, an organic or inorganic antireflective film may also be formed beforehand on a substrate to be used, for example, in order to maximize potential of the radiation-sensitive composition. Furthermore, in order to prevent influences from basic impurities, etc., in the environmental atmosphere, for example, a protective film may be provided on the coating film. In a case of conducting liquid immersion lithography, in order to avoid a direct contact between a liquid immersion medium and the film, a protective film for liquid immersion may also be provided on the film.

### Development Step

In this step, the film exposed in the exposure step is developed. A developer solution to be used in the development is exemplified by an aqueous alkaline solution, an organic solvent-containing liquid, and the like.

Examples of the aqueous alkaline solution include: aqueous alkaline solutions prepared by dissolving at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide (TMAH), pyrrole, piperidine, choline, 1,8-diazabicyclo-[5.4.0]-7-undecene and 1,5-diazabicyclo-[4.3.0]-5-nonene; and the like.

The lower limit of a content of the alkaline compound in the aqueous alkaline solution is preferably 0.1% by mass, more preferably 0.5% by mass, and still more preferably 1% by mass. The upper limit of the content of the alkaline compound is preferably 20% by mass, more preferably 10% by mass, and still more preferably 5% by mass.

As the aqueous alkaline solution, an aqueous TMAH solution is preferred, and a 2.38% by mass aqueous TMAH solution is more preferred.

Examples of an organic solvent in the organic solvent-containing liquid include organic solvents similar to those exemplified in connection with the solvent (D) which may be contained in the radiation-sensitive composition, and the like. Of these, the ester solvents are preferred, and butyl acetate is more preferred.

The lower limit of a content of the organic solvent in the organic solvent developer solution is preferably 80% by mass, more preferably 90% by mass, still more preferably 95% by mass, and particularly preferably 99% by mass.

These developer solutions may be used either alone of one type, or in combination of two or more types thereof. The development is typically followed by washing with water, etc., and drying.

In the case of using the aqueous alkaline solution as the developer solution, a positive tone pattern can be obtained. Alternatively, in the case of using the organic solvent as the developer solution, a negative tone pattern can be obtained.

### EXAMPLES

Hereinafter, the present invention is explained in detail by way of Examples, but the present invention is not limited to these Examples. Measuring methods for physical properties in connection with the Examples are shown below.

### Particle Diameter Analysis

The hydrodynamic radius of the particles (B) was determined by the DLS measurement using a light scattering measurement apparatus ("ALV-5000", available from ALV-GmbH, Germany).

### Preparation of Liquids Containing Organic Acid-Containing Particles (X)

The organic acids (A) and the metal compounds (a) used for preparation of liquids containing the organic acid-containing particles (X) are shown below.

### (A) Organic Acid

A-1: maleic acid (pKa: 1.84)
A-2: methacrylic acid (pKa: 4.66)
A-3: acetic acid (pKa: 4.76)
A-4: trans-2,3-dimethylacrylic acid (pKa: 4.96)

### (a) Metal Compound

MB-1: titanium(IV) tri-n-butoxide stearate (90% by mass solution in butanol)
MB-2: zirconium(IV) tetra-n-butoxide (80% by mass solution in butanol)
MB-3: zirconium(IV) tetra-n-propoxide (70% by mass solution in n-propanol)
MB-4: hafnium(IV) tetraisopropoxide

### Synthesis Example 1

After 10.0 g of the compound (MB-1) was dissolved in 40.0 g of propylene glycol monoethyl ether (PGEE), a mixture of 10.0 g of PGEE and 0.46 g of maleic acid was added thereto. The resulting solution was stirred at room temperature for 1 hour and then PGEE was added thereto to obtain a liquid containing organic acid-containing particles (X-1) having a solid content concentration of 10.0% by mass. The hydrodynamic radius as determined by the DLS technique of the particles (B) contained in the liquid containing organic acid-containing particles (X-1) was less than 1 nm (below the analytical limit).

### Synthesis Example 2

After 4.0 g of the compound (MB-2) was dissolved in 10.0 g of tetrahydrofuran (THF), 8.0 g of methacrylic acid was added thereto, and the mixture was stirred at room temperature for 24 hrs. The resulting solution was mixed with 100 g of hexane, and precipitates thus generated were collected, washed with hexane, and dried in vacuo to give 2.5 g of zirconium-containing particles. The zirconium-containing particles were dispersed in ethyl lactate (EL), and the resulting dispersion was stirred for 1 hour to obtain a liquid containing organic acid-containing particles (X-2) having a solid content concentration of 10.0% by mass. The hydrodynamic radius as determined by the DLS technique of the particles (B) contained in the liquid containing organic acid-containing particles (X-2) was 18 nm.

### Synthesis Example 3

After 4.0 g of the compound (MB-2) was dissolved in 10.0 g of tetrahydrofuran (THF), 8.0 g of methacrylic acid was added thereto, and the mixture was stirred at 60 °C for 24 hrs. The resulting solution was mixed with 100 g of hexane, and precipitates thus generated were collected, washed with hexane, and dried in vacuo to give 2.8 g of zirconium-containing particles. The zirconium-containing particles thus obtained were dispersed in ethyl lactate (EL), and the resulting dispersion was stirred for 1 hour to obtain a liquid containing organic acid-containing particles (X-3) having a solid content concentration of 10.0% by mass. The hydrodynamic radius as determined by the DLS technique of the particles (B) contained in the liquid containing organic acid-containing particles (X-3) was 30 nm.

### Synthesis Example 4

After 4.0 g of methacrylic acid and 2.0 g of acetic acid were added to 4.0 g of the compound (MB-3), the mixture was stirred at room temperature for 72 hrs. Precipitates were found to have been generated. The precipitates were washed with hexane and then dried in vacuo to give 2.0 g of zirconium-containing particles. The zirconium-containing particles thus obtained were dispersed in propylene glycol monomethyl ether acetate (PGMEA), and the resulting dispersion was stirred for 1 hour to obtain a liquid containing organic acid-containing particles (X-4) having a solid content concentration of 10.0% by mass. The hydrodynamic radius as determined by the DLS technique of the particles (B) contained in the liquid containing organic acid-containing particles (X-4) was 2 nm.

### Synthesis Example 5

To 4.2 g of the compound (MB-4), 8.0 g of trans-2,3-dimethyl acrylic acid was added. The mixture was stirred at 65 °C for 30 min and then 0.3 g of water was added thereto. After heating at 65 °C for 18 hrs and addition of 10 g of water, precipitates were found to have been generated. The precipitates were collected by centrifugal separation and dissolved in 5 g of acetone. 10 g of water was added thereto to allow precipitation to occur again. The precipitates were subjected to another centrifugal separation and then to vacuum drying, to give 1.3 g of hafnium-containing particles. The hafnium-containing particles thus obtained were dispersed in propylene glycol monomethyl ether acetate (PGMEA), and the resulting dispersion was stirred for 1 hour to give a liquid containing organic acid-containing particles (X-5) having a solid content concentration of 10.0% by mass. The hydrodynamic radius of the particles (B) contained in the liquid containing organic acid-containing particles (X-5) as determined by the DLS technique was 1.2 nm.

The liquids containing particles (X-1) to (X-5) obtained in Synthesis Examples 1 to 5 are shown in Table 1 below. It is to be noted that an analysis proved that the majority of the organic acid (A) added upon the hydrolytic condensation reaction was contained in the liquid containing organic acid-containing particles (X).

**Table 1**

| | Liquid containing organic acid-containing particles (X) | (a) Metal-containing compound | | (A) Organic acid | | Solvent | Reaction temperature | Hydrodynamic radius of (B) particles |
|---|---|---|---|---|---|---|---|---|
| | | Type | Amount used (g) | Type | Amount used (g) | | | |
| Synthesis Example 1 | X-1 | MB-1 | 10.0 | Maleic acid | 0.46 | PGEE | Room temperature | < 1 nm |
| Synthesis Example 2 | X-2 | MB-2 | 4.0 | Methacrylic acid | 8.0 | EL | Room temperature | 18 nm |
| Synthesis Example 3 | X-3 | MB-2 | 4.0 | Methacrylic acid | 8.0 | EL | 60 °C | 30 nm |
| Synthesis Example 4 | X-4 | MB-3 | 4.0 | Methacrylic acid/Acetic acid | 4.0/2.0 | PGMEA | Room temperature | 2 nm |
| Synthesis Example 5 | X-5 | MB-4 | 4.2 | trans-2,3-dimethylacrylic acid | 8.0 | PGMEA | 65 °C | 1.2 nm |

### Preparation of Radiation-Sensitive Composition

The acid generating agents (C) and the solvents (D) which were used in the preparation of the radiation-sensitive resin compositions are shown below.

### (C) Acid Generating Agent

CC-1: triphenylsulfonium nonafluoro-n-butane-1-sulfonate (compound represented by the following formula (CC-1); van der Waals volume of generated acid: 1.65 x 10⁻²⁸ m³, pKa of generated acid: -3.31)
C1-1: triphenylsulfonium 2-(4-oxoadamantane-1-ylcarbonyloxy)-1,1,3,3,3-pentafluoropropane-1-sulfonate (compound represented by the following formula (C1-1); van der Waals volume of generated acid: 2.76 x 10⁻²⁸ m³, pKa of generated acid: -1.44)
C1-2: 4-cyclohexylsulfonylphenyldiphenylsulfonium 5,6-di(cyclohexyloxycarbonyl)norbornane-2-sulfonate (compound represented by the following formula (C1-2); van der Waals volume of generated acid: 3.80 x 10⁻²⁸ m³, pKa of generated acid: -0.70)
C1-3: triphenylsulfonium 1,2-di(cyclohexyloxycarbonyl)ethane-1-sulfonate (compound represented by the following formula (C1-3); van der Waals volume of generated acid: 3.20 x 10⁻²⁸ m³, pKa of generated acid: -0.81)
C1-4: triphenylsulfonium 6-(adamantan-1-ylcarbonyloxy)-1,1,2,2-tetrafluorohexane-1-sulfonate (compound represented by the following formula (C1-4); van der Waals volume of generated acid: 3.34 x 10⁻²⁸ m³, pKa of generated acid: -2.32)
C2-1: di(triphenylsulfonium) cyclohexane-1,4-di(methyleneoxy-tetrafluoroethanesulfonate) (compound represented by the following formula (C2-1); pKa of generated acid: -2.46)
C2-2: di(4-cyclohexyl sulfonyl phenyl diphenyl sulfonium) 1,1,2,2,3,3-hexafluoropropane-1,3-disulfonate (compound represented by the following formula (C2-2); pKa of generated acid: -3.39)

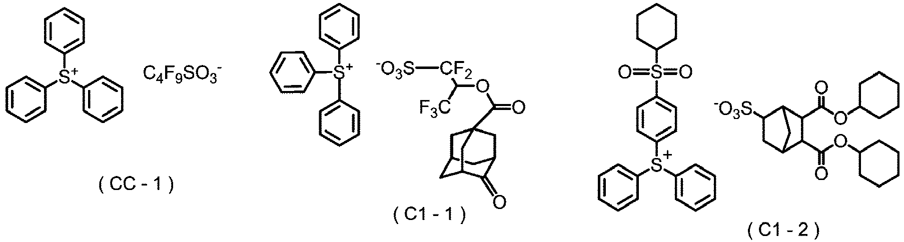

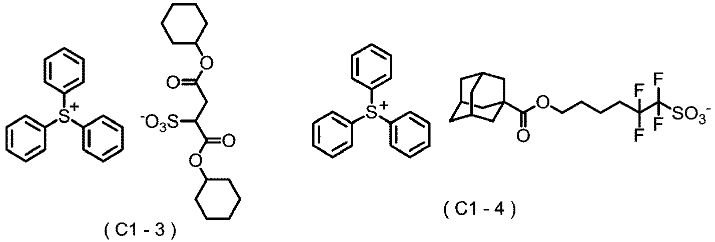

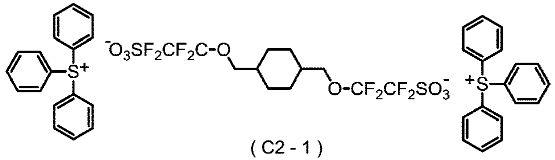

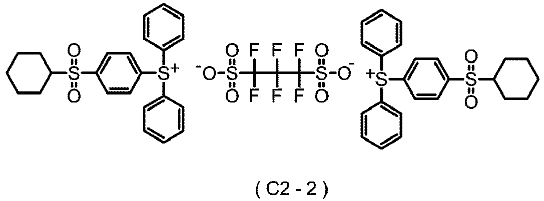

### (D) Solvent

D-1: propylene glycol monomethyl ether acetate
D-2: ethyl lactate

### Comparative Example 1

A radiation-sensitive composition (R-1) was prepared by mixing 1,000 parts by mass of the liquid containing organic acid-containing particles (liquid containing the organic acid and the particles (B)) (X-1) (the total solid content: 100 parts by mass), 27 parts by mass of (C-1) as the acid generating agent (C), and (D-1) as the solvent (D) to obtain a mixed liquid having a solid content concentration of 5% by mass, and then filtering the mixed liquid thus obtained through a membrane filter having a pore size of 0.20 µm.

### Examples 1 to 5 and 7 to 13, and Comparative Examples 2 to 7 and 9

Each radiation-sensitive composition was prepared by a similar operation to that of Comparative Example 1 except that the type and the amount of each component used were as shown in Table 2 below. The symbol "-" in Table 2 indicates that the corresponding component was not used.

**Table 2**

| | Radiation-sensitive compositi on | Liquid containing organic acid-containing particles (X) | | (C) Acid generating agent | | (D) Solvent |
|---|---|---|---|---|---|---|
| | | Type | Amount blended (parts by mass of total solid content) | Type | Amount blended (parts by mass) | Type |
| Comparative Example 1 | R-1 | X-1 | 100 | CC-1 | 27 | D-1 |
| Example 1 | R-2 | X-1 | 100 | C1-1 | 30 | D-1 |
| Comparative Example 2 | R-3 | X-2 | 100 | - | - | D-2 |
| Comparative Example 3 | R-4 | X-2 | 100 | CC-1 | 10 | D-2 |
| Example 2 | R-5 | X-2 | 100 | C1-2 | 16 | D-2 |
| Comparative Example 4 | R-6 | X-3 | 100 | - | - | D-2 |
| Example 3 | R-7 | X-3 | 100 | C1-2 | 16 | D-2 |
| Comparative Example 5 | R-8 | X-4 | 100 | - | - | D-1 |
| Example 4 | R-9 | X-4 | 100 | C1-3 | 5 | D-1 |
| Comparative Example 6 | R-10 | X-5 | 100 | - | - | D-1 |
| Comparative Example 7 | R-11 | X-5 | 100 | CC-1 | 15 | D-1 |
| Example 5 | R-12 | X-5 | 100 | C1-4 | 19 | D-1 |
| Example 7 | R-13 | X-1 | 100 | C2-1 | 26 | D-1 |
| Example 8 | R-14 | X-2 | 100 | C2-1 | 10 | D-2 |
| Comparative Example 9 | R-15 | X-3 | 100 | CC-1 | 10 | D-2 |
| Example 9 | R-16 | X-3 | 100 | C2-1 | 10 | D-2 |
| Example 10 | R-17 | X-4 | 100 | C1-2 | 10 | D-1 |
| Example 11 | R-18 | X-4 | 100 | C2-2 | 7 | D-1 |
| Example 12 | R-19 | X-5 | 100 | C1-2 | 15 | D-1 |
| Example 13 | R-20 | X-5 | 100 | C2-2 | 10 | D-1 |

### Pattern Formation

### Comparative Example 1

The radiation-sensitive composition (R-1) prepared in Comparative Example 1 was spin-coated onto a silicon wafer in CLEAN TRACK ACT-8 available from Tokyo Electron Limited, and subjected to PB at 80 °C for 60 sec to provide a film having an average thickness of 50 nm. Subsequently, the film was irradiated with an electron beam using a simplified electron beam writer ("HL800D" available from Hitachi, Ltd., power: 50 keV, current density: 5.0 ampere/cm²) to permit patterning. Following the irradiation with the electron beam, a development was carried out according to a puddle procedure at 23 °C for 1 min using butyl acetate in the CLEAN TRACK ACT-8. Thereafter, the substrate was dried, whereby a negative tone pattern was formed.

### Examples 1 to 5 and 7 to 13, and Comparative Examples 2 to 7 and 9

Each negative tone patterns was formed by a similar operation to that of Comparative Example 1 except that the radiation-sensitive compositions as shown in Table 3 were used.

### Example 6 and Comparative Example 8

A similar operation to that in Comparative Example 1 was carried out until the irradiation with the electron beam, except that each of the radiation-sensitive compositions shown in Table 4 was used. Thereafter, a development was carried out according to a puddle procedure at 23 °C for 1 min using a 2.38 % by mass tetramethylammonium hydroxide (TMAH) aqueous solution in the CLEAN TRACK ACT-8. Thereafter, the substrate was washed with pure water and then dried, whereby a positive tone pattern was formed.

### Evaluations

Each pattern thus formed was evaluated for the sensitivity and the nanoedge roughness property by the method described below. The results are shown in Table 3.

### Sensitivity

An exposure dose at which a line and space pattern (1L 1S) configured with a line part having a line width of 150 nm and a space part formed by neighboring line parts with an interval of 150 nm was formed to give a line width of 1:1 was defined as "optimal exposure dose", and the "optimal exposure dose" was defined as "sensitivity" (µC/cm²).

### Nanoedge Roughness Property

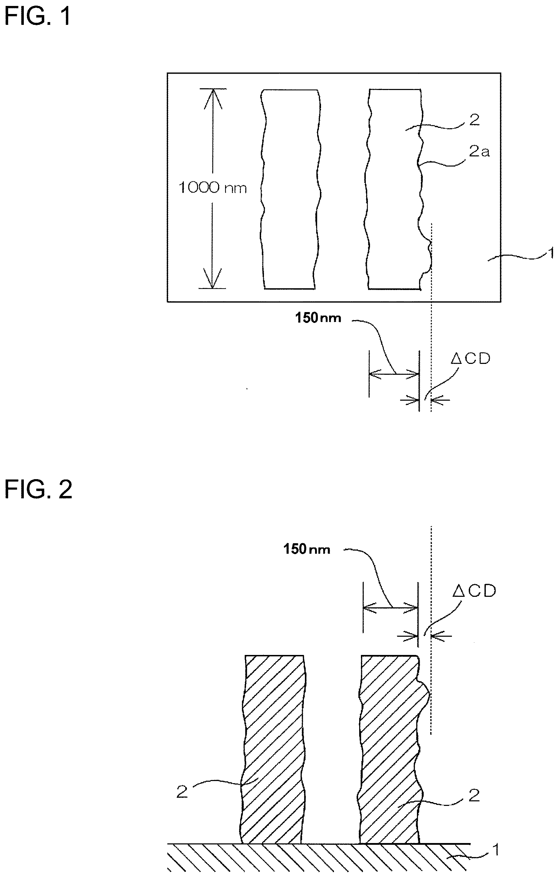

The line patterns of the line and space pattern (1L 1S) were observed using a high-resolution FEB critical dimension measurement device ("S-9220" available from Hitachi, Ltd.). Arbitrary twenty points on the substrate were observed, and with respect to the observed shape, a difference "ΔCD" between an intended line width of 150 nm and a maximum line width of the line part 2 was measured in relation to irregularities generated along the side lateral surface 2a of the line part 2 of the film provided on the silicon wafer 1 as shown in FIGS. 1 and 2. An averaged value of the ΔCD was defined as "nanoedge roughness" (nm). The nanoedge roughness property was determined to be: "AA" (extremely favorable) in the case of being no greater than 15 nm; "A" (favorable) in the case of being greater than 15.0 nm and no greater than 16.5 nm; and "B" (unfavorable) in the case of being greater than 16.5 nm. It is to be noted that the irregularities shown in FIGS. 1 and 2 are exaggerated.

**Table 3**

| | Radiation-sensitive composition | Sensitivity (µC/cm²) | Nanoedge roughness property | |
|---|---|---|---|---|
| | | | Measured value (nm) | Evaluation |
| Comparative Example 1 | R-1 | 14 | 16.6 | B |
| Example 1 | R-2 | 15 | 14.2 | AA |
| Comparative Example 2 | R-3 | 10 | 15.5 | A |
| Comparative Example 3 | R-4 | 6 | 16.7 | B |
| Example 2 | R-5 | 7 | 14.5 | AA |
| Comparative Example 4 | R-6 | 10 | 15.8 | A |
| Example 3 | R-7 | 7 | 16.3 | A |
| Comparative Example 5 | R-8 | 17 | 15.2 | A |
| Example 4 | R-9 | 11 | 14.7 | AA |
| Comparative Example 6 | R-10 | 35 | 15.5 | A |
| Comparative Example 7 | R-11 | 24 | 16.8 | B |
| Example 5 | R-12 | 26 | 14.9 | AA |
| Comparative Example 8 | R-8 | 25 | 17.1 | B |
| Example 6 | R-9 | 27 | 14.5 | AA |
| Example 7 | R-13 | 10 | 15.2 | A |
| Example 8 | R-14 | 12 | 15.4 | A |
| Comparative Example 9 | R-15 | 9 | 16.4 | A |
| Example 9 | R-16 | 7 | 15.8 | A |
| Example 10 | R-17 | 12 | 15.3 | A |
| Example 11 | R-18 | 10 | 14.8 | AA |
| Example 12 | R-19 | 10 | 16.0 | A |
| Example 13 | R-20 | 8 | 14.9 | AA |

From the results shown in Table 3, it was verified that an improvement of the sensitivity was enabled by combining: the organic acid; the particles comprising the metal oxide as a principal component; and the acid generating agent capable of generating an acid having a pKa value less than the predetermined value and a van der Waals volume no less than the predetermined value, or the acid generating agent having a plurality of groups that are capable of generating an acid having a pKa value less than the predetermined value, while the nanoedge roughness performance is enabled to be maintained or improved compared to a case of containing no acid generating agent. It was also verified that, due to the hydrodynamic radius of the particles comprising the metal oxide as a principal component being no greater than 20 nm, the nanoedge roughness can be further reduced. It is to be noted that an exposure to an electron beam is generally known to give a tendency similar to that in the case of the exposure to EUV. Therefore, the radiation-sensitive composition according to the embodiment of the present invention is expected to be superior in the sensitivity and the nanoedge roughness performance also in the case of an exposure to EUV.

### [INDUSTRIAL APPLICABILITY]

Due to a combination of: the organic acid; the particles comprising a metal oxide as a principal component; and the acid generating agent that is capable of generating a specific acid, the radiation-sensitive composition and the pattern-forming method according to the embodiments of the present invention enable a pattern superior in nanoedge roughness property to be formed with high sensitivity. Therefore, these can be suitably used for a processing process of semiconductor devices, and the like, in which further progress of miniaturization is expected in the future.

### [EXPLANATION OF THE REFERENCE SYMBOLS]

1 Silicon wafer
2 Line part in pattern
2a Side lateral surface of line part in pattern

## Claims

1. A radiation-sensitive resin composition comprising:
an organic acid;
particles comprising a metal oxide as a principal component; and
an acid generating agent that is capable of generating an acid upon irradiation with a radioactive ray, wherein
the acid generating agent satisfies at least one of conditions (i) and (ii):
(i) a pKa that is a logarithmic value of a reciprocal of an acid dissociation constant Ka of the acid generated from the acid generating agent is less than a pKa of the organic acid, and a van der Waals volume of the acid is no less than 2.1 x 10⁻²⁸ m³; and
(ii) the acid generating agent comprises a plurality of groups that are capable of generating an acid, and a pKa that is a logarithmic value of a reciprocal of an acid dissociation constant Ka of the acid is less than the pKa of the organic acid.

2. The radiation-sensitive composition according to claim 1, wherein a metal element constituting the metal oxide comprises zirconium, hafnium, nickel, cobalt, tin, indium, titanium, ruthenium, tantalum, tungsten, or a combination thereof.

3. The radiation-sensitive composition according to claim 1 or 2, wherein a content of the acid generating agent with respect to a total solid content of the composition is no less than 1% by mass and no greater than 50% by mass.

4. The radiation-sensitive composition according to any one of claims 1 to 3, wherein a hydrodynamic radius of the particles as determined by a dynamic light scattering analysis is no greater than 20 nm.

5. A pattern-forming method comprising:
providing a film;
exposing the film; and
developing the film exposed,
wherein the film is provided from the radiation-sensitive composition according to any one of claims 1 to 4.

6. The pattern-forming method according to claim 5, wherein a developer solution used in the developing is an aqueous alkaline solution.

7. The pattern-forming method according to claim 5, wherein a developer solution used in the developing is an organic solvent-containing liquid.

8. The pattern-forming method according to any one of claims 5 to 7, wherein a radioactive ray used in the exposing is an extreme ultraviolet ray or an electron beam.
